# EUROPEAN PATENT APPLICATION

(11) **EP 2 450 937 A2**
(43) Date of publication of application: **09.05.2012**
(21) Application number: 11187867.4
(22) Date of filing: 04.11.2011
(51) Int. Cl.: H01J 37/34

(54) **Magnetic circuit for sputtering apparatus**

(30) Priority: 05.11.2010 JP 2010248474
(71) Applicant: Shin-Etsu Chemical Co., Ltd., Chiyoda-ku Tokyo (JP)
(72) Inventor: Kbayashi, Hideki, Fukui-ken (JP)
(74) Representative: Maschio, Antonio

(57) **Abstract**

To provide a magnetic circuit for a magnetron sputtering apparatus, which produces arc-shaped magnetic field lines of high magnetic field strength over a target surface, and has an improved demagnetization resistance. The magnetic circuit includes: an inner magnet; an outer magnet having a magnetization direction opposite to that of the inner magnet, and surrounding the inner magnet; a horizontally magnetized magnet disposed between the inner and outer magnets, and magnetized in a direction perpendicular to those of the inner and outer magnets, and in a direction from the inner magnet to the outer magnet, or from the outer magnet to the inner magnet; and a yoke configured so that a magnetic flux passes through the yoke between the inner and outer magnets, in which a magnetic coercive force of the horizontally magnetized magnet is greater in a region closer to the target side than in a center of the magnet interior.

## Description

### BACKGROUND OF THE INVENTION

### 1. Field of the Invention

The present invention relates to a magnetron sputtering apparatus which is used for forming of a wiring layer of a semiconductor device, manufacturing of hard disk recording media, and the like, and relates to a magnetic circuit for the magnetron sputtering apparatus which circuit applies a magnetic field to a target.

### 2. Description of the Related Art

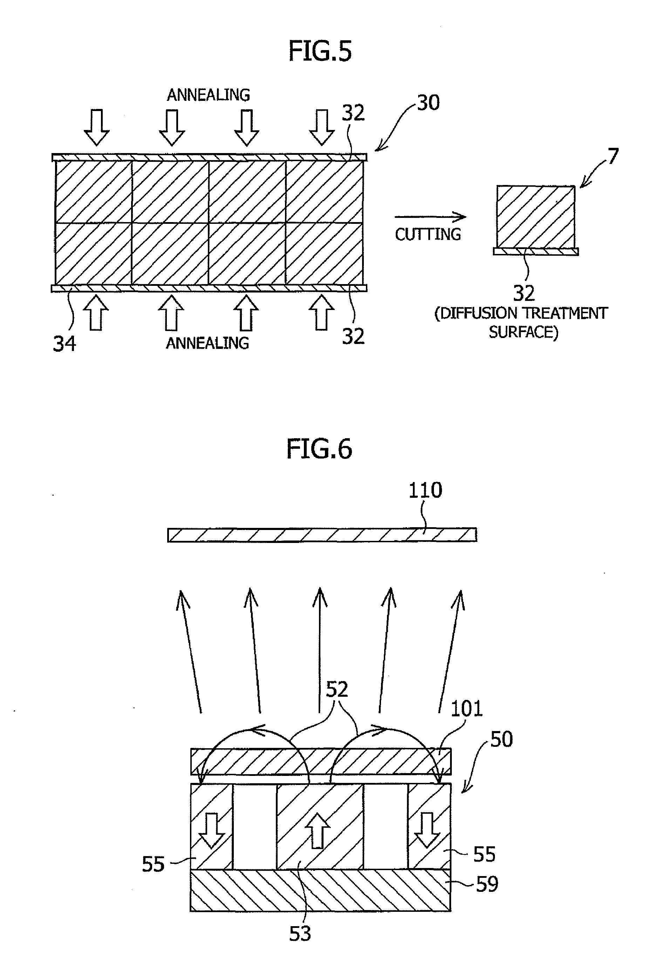

Magnetron sputtering apparatuses are widely used in a film depositing technique for materials of electric and electronic components. In such a magnetron sputtering apparatus, a target material or target 101 is placed facing a substrate 110 which is placed in a vacuum chamber, and a magnetic circuit 50 is disposed in a back side of the target so as to provide an arc-shaped magnetic field represented by arc-shaped magnetic field lines 52 over and near a surface of the target, as shown in FIG. 6. In a sputtering process, a high voltage is applied between the substrate 110 and the target 101 in inert gas atmosphere to ionize electrons. The ionized electrons collide with an inert gas and generate plasma gas. Cations in the plasma attack the target so that particles are ejected from the target and deposited to the opposing substrate. This makes film deposition on the substrate. In general, as illustrated in FIG. 6, the arc-shaped magnetic field lines 52 over the surface of the target can be obtained by the following arrangement of a magnetic circuit 50: an inner magnet 53 having a magnetization direction perpendicular to the target's surface is placed in an interior, and an outer magnet 55 having a magnetization direction opposite to that of the inner magnet 53 is placed on the outer side of the inner magnet 53. Further, the inner magnet 53 and the outer magnet 55 are secured onto a yoke 59 to form a magnetic circuit. The yoke 59 allows magnetic flux to pass between the inner magnet and the outer magnet (reflux flow of magnetic flux) thereby improving the efficiency of the magnetic circuit and increasing the strength of the surface magnetic field. In the figures, solid-white arrows indicate the direction of magnetization.

In recent years, semiconductor devices are manufactured in a greater density, and accordingly further miniaturization of wiring is demanded. In such a situation, there is a need to further improve the film depositing performance of the sputtering apparatus. One method to address this need is to enhance the directivity of particles ejected from the target by increasing the distance between the target and the substrate on which a film is to be deposited. The ejected particles with an enhanced directivity can approach the substrate at an angle closer to upright angle so that film deposition can be performed sufficiently even in a microgroove on the substrate. In order to increase the directivity of ejected particles, it is necessary to decrease the collision frequency between ejected particles, or between ejected particles and the other floating particles. Accordingly, it is necessary to decrease the ambient pressure in the sputtering apparatus. However, the decreased ambient pressure will lead to a decline of plasma density, and thereby electrical discharge might become unstable. To prevent the decline of plasma density and to increase the plasma density, the strength of the magnetic field over target's surface may be increased. Moreover, since the strength of the magnetic field of target's surface is increased, it may be possible to increase the target thickness thereby extending the production life of the target.

It has been reported that a magnetic circuit can be produced by using magnets having high residual magnetization to form the inner magnet and the outer magnet, and by disposing a horizontally magnetized magnet between the inner magnet and the outer magnet, which horizontally magnetized magnet has a perpendicular magnetization direction with respect to the magnetization direction of the inner and outer magnets, and is formed of a magnet having a high magnetic coercive force (see, for example, JP2000-219965A). The magnetic circuit thus arranged can significantly increase the strength of the arc-shaped magnetic field lines compared to a magnetic circuit without the horizontally magnetized magnet. Moreover, since a magnet having a high magnetic coercive force is used for the horizontally magnetized magnet, even if a reverse magnetic field from the inner and outer magnets acts on the horizontally magnetized magnet, demagnetization will not occur.

A magnet will be demagnetized if a reverse magnetic field which is larger than its magnetic coercive force acts thereon. To prevent demagnetization during its use, a magnet having a magnetic coercive force greater than the reverse magnetic field acting thereon is used. However, in general, when the magnetic coercive force of a sintered NdFeB magnet is made greater, the residual magnetization of the sintered NdFeB magnet becomes lower, and vice versa. Therefore, using a magnet having an excessively high magnetic coercive force might lead to a decline of the strength of the magnetic field to be produced.

In recent years, there are reported techniques for improving magnetic coercive force without decreasing residual magnetization by diffusing Dy (Dysprosium) or Tb (Terbium) from the surface of a sintered magnet to its interior (see, for example, International Publication of W02006/043348, and Machida K., Kawasaki T., Suzuki S., Itoh M., and Horikawa T., "Improvement of Grain Boundaries and Magnetic Properties ofNd-Fe-B Sintered Magnets (in Japanese)," Abstracts of Spring Meeting, p202, 2004, Japan Society of Powder and Powder Metallurgy.) Since such techniques can effectively concentrate Dy or Tb at grain boundaries, it is possible to increase the magnetic coercive force with almost no decrease of residual magnetization.

### SUMMARY OF THE INVENTION

If such a treatment to diffuse Dy or Tb from the magnet surface is applied to a magnet which is not compact in size, the magnetic coercive force will not increase in the magnet interior, and the magnetic coercive force will gradually increase from the interior to the surface, thus requiring attention during its use (see, for example, JP2010-135529A).

In view of the above, an obj ect of the present invention is to provide a magnetic circuit for a magnetron sputtering apparatus, which produces arc-shaped magnetic field lines of greater magnetic field strength, and has an improved demagnetization resistance.

In order to achieve the above object, the inventor has found and taken an advantage of the fact that the strength of the magnetic field represented by the arc-shaped magnetic field lines can be increased while preventing the demagnetization of a horizontally magnetized magnet, by using the horizontally magnetized magnet formed of a magnet which is subjected to a diffusion treatment of Dy or Tb from a target-facing surface of the horizontally magnetized magnet so that the magnetic coercive force of a target side region of the horizontally magnetized magnet becomes greater in value than the magnetic coercive force of the center of the horizontally magnetized magnet. Specifically, the inventor has devised a magnetic circuit for a magnetron sputtering apparatus, comprising: an inner magnet having a magnetization direction perpendicular to a surface of a target; an outer magnet disposed around the inner magnet and having a magnetization direction opposite to that of the inner magnet; and a horizontally magnetized magnet disposed between the inner magnet and the outer magnet and having a magnetization direction perpendicular to those of the inner magnet and the outer magnet, in which the horizontally magnetized magnet is formed of a magnet which is subjected to a diffusion treatment of Dy or Tb from a target-facing surface of the horizontally magnetized magnet so that the magnetic coercive force of a target side region of the horizontally magnetized magnet becomes greater in value than the magnetic coercive force of the center of the interior of the horizontally magnetized magnet.

According to one aspect of the present invention, since the horizontally magnetized magnet formed of a permanent magnet, which has a high residual magnetization and in which the target side region has a greater magnetic coercive force than the center of the interior is used in the magnetic circuit for the magnetron spattering apparatus, the magnetic circuit can produce an arc-shaped magnetic field line having a greater magnetic field strength than that of conventional circuit. Accordingly, a greater plasma density can be obtained at a low pressure, and the directivity of target particles can be improved. Therefore, it is possible to provide a sputtering apparatus which enables the film deposition for a finer wiring structure. Further, since the enhancement of the arc-shaped magnetic field line enables to obtain a sufficient magnetic field strength over target's surface, it is possible to increase the target thickness, and accordingly the production life of the target can be extended. Furthermore, since one surface of the horizontally magnetized magnet may be treated to increase the magnetic coercive force thereof, there may be no need of applying a diffusion treatment to all the surfaces of magnet. It is possible to mass-produce horizontally magnetized magnets with enhanced magnetic coercive force, and to improve the film depositing performance of a sputtering apparatus with an additional simple process, by assembling multiple horizontally magnetized magnets and by treating only one surface thereof in one operation to diffuse Dy or Tb from the surface.

### BRIEF DESCRIPTION OF THE DRAWINGS

FIGS. 1A and 1B are each a perspective view of a magnetic circuit for a magnetron sputtering apparatus including a horizontally magnetized magnet according to the present invention;
FIG. 2A is a schematic sectional view of a magnetic circuit with a target being placed thereon according to the present invention, and FIG. 2B is a graph to illustrate the relationship between a height position of the horizontally magnetized magnet included in the magnetic circuit and the magnetic coercive force;
FIG. 3 is a schematic sectional view to illustrate the region where a reflux flow 4 of magnetic field produced by an inner magnet and an outer magnet principally acts on the horizontally magnetized magnet as a reverse magnetic field;
FIG. 4 is a graph to illustrate the relationship between the height position and the magnetic coercive force of the horizontally magnetized magnet when an overall treatment is carried out;
FIG. 5 is a conceptual view to illustrate the procedure to effectively perform a one-surface diffusion treatment; and
FIG. 6 is a schematic sectional view to illustrate a sputtering method using a conventional magnetron sputtering apparatus.

### DETAILED DESCRIPTION OF THE PREFERRED EMBODIMENTS

Hereafter, the magnetic circuit for a sputtering apparatus of the present invention will be described more specifically with reference to the accompanying drawings. The same reference numerals are given to the components which function in the same manner. Note that the present invention will not be limited to embodiments to be described below.

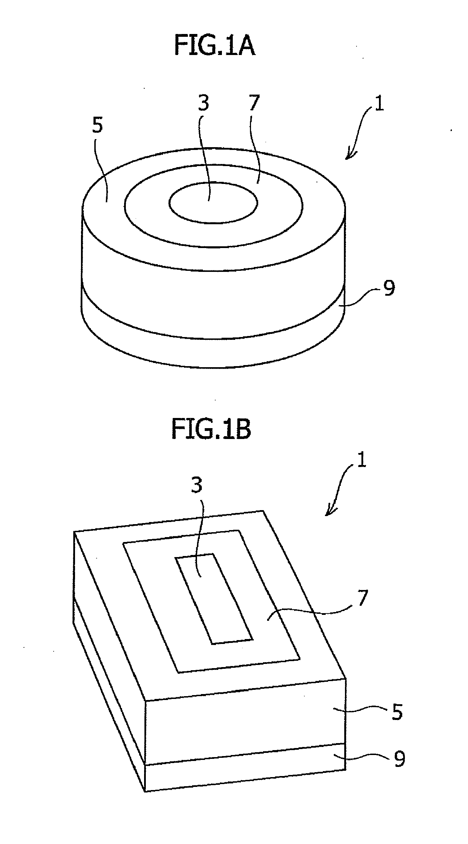

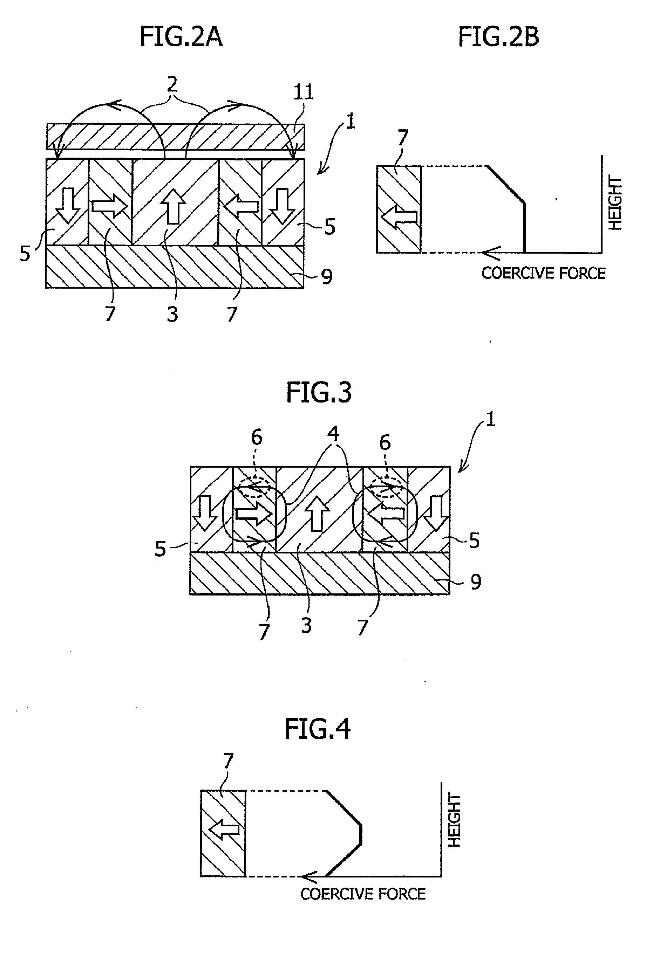

FIG. 1 illustrates an example of the magnetic circuit according to the present invention. A magnetic circuit 1 for a sputtering apparatus according to the present invention comprises: an inner magnet 3 having a vertical magnetization direction; an outer magnet 5 disposed around the inner magnet 3 and having a magnetization direction opposite to (antiparallel with) that of the inner magnet; and a horizontally magnetized magnet 7 placed between the inner magnet 3 and the outer magnet 5, and having a magnetization direction perpendicular to those of the inner and outer magnets. Further, these magnets may be secured to a yoke 9 with an adhesive, or the like. The magnetic field produced by the magnetic circuit forms an arc-shaped magnetic field line 2 over the surface of a target 11 as shown in FIG. 2A. The magnetic field produced by the horizontally magnetized magnet 7 at a target side has the same direction as that of the magnetic field produced by the inner magnet 3 and the outer magnet 5, and therefore the strength of the surface magnetic field becomes greater compared with the case without the horizontally magnetized magnet. It is noted that the magnetization direction of each magnet may be in an opposite pattern to that of FIG. 2A. That is, it may be arranged such that the inner magnet 3 has a downward magnetization direction (the arrow points toward the yoke), the outer magnet 5 has an upward magnetization direction, and the horizontally magnetized magnet 7 has a magnetization direction directing toward an outer peripheral side of the magnetic circuit. In this case, the arc-shaped magnetic field line 2 will be directed from the outer peripheral side to the center.

With regard to the magnetic coercive force distribution of the horizontally magnetized magnet, the magnetic coercive force is greater in the region of the target side than in the center of the interior as shown in FIG. 2B. Referring to FIG. 3, description will be made on that a magnet having such a distribution of magnetic coercive force is effective for a magnetic circuit for a sputtering apparatus. In the magnetic circuit 1 provided with the horizontally magnetized magnet 7 between the inner magnet 3 and the outer magnet 5 as shown in FIG. 3, the reflux flow of magnetic flux produced by the inner magnet and the outer magnet acts on the interior of the horizontally magnetized magnet 7 as well. This interior flow of magnetic flux acts in a target side region 6 of the horizontally magnetized magnet as a magnetic field having a direction opposite to the magnetization direction of the horizontally magnetized magnet. Since the region on which such reverse magnetic field is acting may be easily demagnetized, it is necessary to increase the magnetic coercive force thereof. To prevent this demagnetization, conventional magnetic circuits employ a magnet without a diffusion treatment of Dy or Tb, that is, a magnet having a high magnetic coercive force and a low residual magnetization. In contrast in the present invention, a magnet which has been subjected to a diffusion treatment from the target-facing surface is used as the horizontally magnetized magnet 7. Accordingly, a high magnetic coercive force even in the target side region of the horizontally magnetized magnet 7 can be kept without a decline of the residual magnetization and the strength of the arc-shaped magnetic field line can be increased more than in a conventional magnetic circuit. In a magnet subjected to the diffusion treatment, the magnetic coercive force can be increased while the residual magnetization remains high as previously described. When this magnet is used for the horizontally magnetized magnet of the magnetic circuit for a sputtering apparatus, it becomes possible to increase the strength of the arc-shaped magnetic field line over the target's surface more than in the conventional magnetic circuits. This enables to obtain a greater plasma density at a lower pressure, and thus the directivity of the ejected particles from the target can be enhanced. Therefore, a sputtering apparatus that enables the film deposition of a finer wiring structure can be provided. Furthermore, since as a result of the strength of the arc-shaped magnetic field line being increased, a sufficient magnetic field strength can be obtained on the target's surface even if the target thickness increases. It is possible to increase the target thickness and to extend the production life of the target.

The approach for diffusing Dy or Tb from the surface toward the inside of the magnet in the coating method or the sputtering method is described in W02006/043348A1 and can be sometimes called "surface treatment by a grain boundary diffusion alloy method". In this method, preferably, a sintered magnet body and powder present on the surface of the sintered magnet body are thermally treated at a temperature lower than or equal to a sintering temperature of the sintered magnet body under a vacuum or an inert gas. The powder comprises one or more selected from the group consisting of oxides, fluorides and acid fluorides of one or more elements selected from rare earth elements including Y and Sc. The sintered magnet body may be preferably a sintered magnet body having an R¹-Fe-B composition wherein R¹ represents one or more selected from rare earth elements including Y and Sc.

However, there is a limitation on an area in which the magnetic coercive force can be increased by a diffusion treatment. Thus, if a horizontally magnetized magnet having an excessively large size is subjected to the diffusion treatment, an advantageous increase in magnetic coercive force may not be achieved in the entire horizontally magnetized magnet.

According to JP2010-135529A, the increase in magnetic coercive force by a diffusion treatment can be obtained up to a depth of about 6 mm from the surface of the treated magnet. The region where the reverse magnetic field acts in the horizontally magnetized magnet as indicated in FIG. 3 is from the target side surface to a depth of about 1/2 of the dimension of the magnet in the direction perpendicular to the target-facing surface (i.e., magnet height), and the region where an especially strong reverse magnetic field acts is from the target side surface to a depth of about 1/5 of the magnet height. Therefore, when the height of the magnet is much larger than 30 mm, the region of the reverse magnetic field will become much larger than the region with the depth of up to about 6 mm at which the effect of increasing the magnetic coercive force by a diffusion treatment can be obtained. Thus, the reverse magnetic field region cannot be negated by the magnetic coercive force increased by a diffusion treatment. Moreover, when the magnet is too small, the strength of arc-shaped magnetic field line itself produced by the magnetic circuit may become smaller. Therefore, it is preferable to use a magnet, as a horizontally magnetized magnet, having a height of about 5 to 30 mm and having been subjected to a diffusion treatment.

As so far described, by using a magnetic circuit comprising a magnet subjected to a diffusion treatment of Dy or Tb as the horizontally magnetized magnet, it is possible to improve the film depositing performance of the magnetron sputtering apparatus.

The magnetic circuit for a sputtering apparatus according to the present invention is configured by combining the inner magnet, the outer magnet, and the horizontally magnetized magnet as described above, in which the value of magnetic coercive force of the horizontally magnetized magnet is configured to be not uniform and to be greater in the region closer to the target than in the center of the magnet interior. The magnetic circuit like this includes a yoke for securing the magnets thereon. The magnets may be secured on the yoke with an adhesive, or the like. Such magnetic circuit for a sputtering apparatus is exemplified in FIG. 2A. The outline of the magnetic circuit is exemplified in FIG. 1. FIG. 2A is a sectional view of the magnetic circuit shown in FIG. 1. Each of the inner magnet, the outer magnet, and the horizontally magnetized magnet, which is comprised by the magnetic circuit of FIG. 1, may not be limited to a magnet of unitary body, but may comprise a magnet which is divided into multiple pieces. The magnet as a whole may be circular as shown in FIG. 1A, or rectangular as shown in FIG. 1B. A circular magnetic circuit may be used with a circular target and used to deposit a film on a Si wafer, for example. A rectangular magnetic circuit may be used with a rectangular target and used in manufacturing process of liquid crystal panels, for example. As shown in FIG. 2A, the cross-sectional shapes of the magnets can be a rectangular shape, and each magnet can be placed adj acent to another magnet. The magnetization direction of the inner magnet is a direction from the magnetic circuit to the target, or a reverse direction thereof, and the magnetization direction of the outer magnet is 180 degrees opposite to that of the inner magnet. The magnetization direction of the horizontally magnetized magnet is perpendicular to the magnetization directions of the inner magnet and the outer magnet, and is the direction to increase the strength of the magnetic field over a target surface produced by the inner magnet and the outer magnet. For example, it is the direction from the inner magnet to the outer magnet, or the direction from the outer magnet to the inner magnet. As a result, a strong arc-shaped magnetic field line 2 is formed in a space over the target surface by the magnetic circuit. Therefore, a magnetron sputtering apparatus of improved performance can be provided by incorporating this magnetic circuit in the sputtering apparatus.

Each of the magnets to be used is preferably a permanent magnet, and more preferably a sintered NdFeB rare-earth magnet. A sintered rare-earth magnet has both a far more improved residual magnetization and magnetic coercive force compared with other magnets, and since the sintered NdFeB rare-earth magnet has lower cost and a more improved residual magnetization than a sintered SmCo rare-earth magnet, it is a preferable magnet material for a high-performance sputtering apparatus. Further, the above described diffusion treatment is a treatment effective particularly for the sintered NdFeB rare-earth magnets.

In the present invention, as described above, a magnet in which the magnetic coercive force in the target side region of the horizontally magnetized magnet is larger than the magnetic coercive force of the center of the interior thereof, can be formed by diffusing Dy or Tb from the magnet surface to the interior by a coating method or a sputtering method. Since it is enough if the magnetic coercive force is increased only in the target side region of the horizontally magnetized magnet by a diffusion treatment, only one surface of the magnet may be treated in the diffusion treatment process. For example, the diffusion treatment may be performed by masking the surfaces other than the surface to be treated. However, when treating only one surface of the magnet in the coating method or sputtering method causes additional cost and/or impairs the productivity due to the introduction of an extra process such as masking, compared with an all-surface overall treatment, the overall treatment instead of one surface treatment may be adopted. In this case, in the magnet having undergone the overall treatment, although the magnetic coercive force is increased in all the surfaces, that will not adversely affect the sputtering apparatus and there will be no problem provided that the magnetic coercive force over the target side surface is increased. A state of the magnetic coercive force of the horizontally magnetized magnet in such a case is shown in FIG. 4.

Alternatively, there may be employed a method for making the one surface treatment having an improved productivity and lower cost than the overall treatment by devising the process. By forming a coating layer 34 containing Dy or Tb on both surfaces 32 of a large magnet block 30 and then heat-treating (annealing) the magnet block 30, as a diffusion treatment as shown in FIG. 5, and cutting the magnet into pieces with final shapes after the diffusion treatment, it is possible to subject a large amount of magnets to a diffusion treatment at a time, thereby achieving improved productivity and lower cost.

Since the increase of the magnetic coercive force by a diffusion treatment can be expected from the surface to a depth of about 6 mm, the region where the magnetic coercive force is increased may become insufficient for an excessively large horizontally magnetized magnet. While the magnetic flux produced by the inner magnet and the outer magnet circulates as shown in FIG. 3, this reflux flow of magnetic flux acts as a reverse magnetic field to the magnetization direction of the horizontally magnetized magnet in the target side region of the horizontally magnetized magnet. The region where the reverse magnetic field acts in the horizontally magnetized magnet is from the target side surface to a depth of about 1/2 of the magnet height, and the region where an especially strong reverse magnetic field acts is from the surface to a depth of about 1/5 of the magnet height. When, for example, the magnet height is 30 mm, a strong reverse magnetic field acts up to a depth of 6 mm which is 1/5 of the height. Accordingly, the diffusion treatment is effective for such reverse magnetic field since the magnetic coercive force increases in a region up to a depth of about 6 mm as a result of the diffusion treatment. On the other hand, if the magnet height is far larger than 30 mm, since the region where the magnetic coercive force increases is too small with respect to the size of the region of the reverse magnetic field, the demagnetization of the magnet cannot be prevented even if a diffusion treatment is performed. When the magnetic height is less than 12 mm, the magnetic coercive force slightly increases at the center of the magnet interior, in addition to the increase in the target side region, as a result of the diffusion treatment. This increase at the center of the magnet interior will have no adverse effect on the sputtering apparatus. Accordingly, the present invention also works effectively for magnets having a magnet height of not more than 12 mm. However, since an excessively small size of the magnet may cause a decline of the strength of the magnetic field and a deterioration of the film depositing performance, a magnet height of not less than 5 mm is preferable.

The magnetron sputtering apparatus that incorporates the above described magnetic circuit can be also included in the present invention.

### Examples

Hereafter, specific embodiments of the present invention will be described in detail by way of examples. However, it should not be construed that the content of the present invention is limited to those embodiments.

### Example 1

As an inner magnet, provided was a cylindrical magnet having dimensions of a diameter of 40 mm and a height of 30 mm and being magnetized in height direction, formed of a sintered NdFeB magnet having a residual magnetization of 1.42 T and a magnetic coercive force of 900 kA/m. As an outer magnet, provided were twelve concentric arc-shaped magnets having the same magnetic properties and having dimensions of an outer diameter of 120 mm, an inner diameter of 80 mm, a circular arc angle of 30 degrees, and a height of 30 mm and being magnetized in its height direction. As a horizontally magnetized magnet, provided were twelve concentric arc-shaped magnets having the same magnetic properties and having dimensions of an outer diameter of 80 mm, an inner diameter of 40 mm, a circular arc angle of 30 degrees, and a height of 30 mm and being magnetized in a direction toward the center of the circular arc. Only the horizontally magnetized magnet was subjected to a diffusion treatment. The diffusion treatment was carried out such that granular dysprosium fluoride was mixed with ethanol, and the horizontally magnetized magnet with surfaces other than one concentric arc surface being masked was dipped into the mixture, followed by being heat-treated in Ar atmosphere at 900°C for one hour. The results obtained by a measurement of the magnetic coercive force at the diffusion-treatment surface side and the magnetic coercive force at the center of the interior of this magnet were 1300 kA/m and 900 kA/m, respectively. Thus, the magnetic coercive force at the diffusion-treatment surface side was increased by 400 kA/m.

These magnets were secured by an adhesive to a yoke having a diameter of 120 mm and a height of 10 mm, and made of SS400. First, the inner magnet was glued to the yoke center; then twelve concentric arc-shaped horizontally magnetized magnets were disposed and glued around the inner magnet in a circular form; and further the twelve outer magnets were arranged around the twelve horizontally magnetized magnets in a circular form to be glued to the yoke. The horizontally magnetized magnets were disposed such that the diffusion treatment surface faces the target side. The magnetization direction of each magnet was the same as that shown in FIG. 2.

In order to evaluate the obtained magnetic circuit, the magnetic field on the target side was measured. A maximum value of the horizontal component of magnetic field at a distance of 10 mm above from the magnet surface was 0.489T.

### Comparative Example 1

Next, as Comparative Example 1, a magnetic circuit was provided with the same configuration as that of Example 1 excepting the horizontally magnetized magnet, in which a magnet having the same shape and the same magnetization direction as those of the horizontally magnetized magnet of Example 1, and having a residual magnetism of 1.35T and a magnetic coercive force of 1300 kA/m was used without diffusion treatment as the horizontally magnetized magnet. The magnet surface magnetic field of the fabricated magnetic circuit was measured at the same conditions as those of Example 1. The maximum value of the horizontal component of magnetic field was 0.474T.

The strength of magnetic field declined about 3% compared with that of Example 1. The reason of this decline may be considered that although the magnetic coercive force of the horizontally magnetized magnet was 1300 kA/m which can be an enough value so as not to be demagnetized, the residual magnetism was lowered than Example 1 by 0.07T, so that the strength of surface magnetic field declined. Comparative Example 1 simulates a conventional magnetic circuit for a sputtering apparatus.

### Comparative Example 2

A magnetic circuit was provided with the same configuration as that of Example 1 excepting the horizontally magnetized magnet, in which a magnet having the same magnetic properties (a residual magnetism of 1.42T and a magnetic coercive force of 900 kA/m), the same dimensions and the same magnetization direction as those of the horizontally magnetized magnet of Example 1 was used without diffusion treatment as the horizontally magnetized magnet. The magnet surface magnetic field of the fabricated magnetic circuit was measured at the same conditions as those of Example 1, the maximum value of the horizontal component of magnetic field was 0.420T.

The reason why the magnetic field significantly declined can be considered that the magnetic coercive force of the horizontally magnetized magnet was low, and demagnetization occurred due to a reverse magnetic field in the target side region of the horizontally magnetized magnet.

From the above described Example 1 and Comparative Examples 1 and 2, it is evident that by using a horizontally magnetized magnet, in which the magnetic coercive force at the target side region is greater than at the center of the interior thereof as a result of a diffusion treatment, a magnetic circuit for a sputtering apparatus having a greater strength of surface magnetic field compared with a conventional circuit without the diffusion treatment can be obtained.

## Claims

1. A magnetic circuit for a magnetron sputtering apparatus, in which the magnetic circuit is disposed at a back side of a target and generates a leakage magnetic field that draws an arc-shaped magnetic field line over a surface of the target, the magnetic circuit comprising:
an inner magnet;
an outer magnet having a magnetization direction opposite to that of the inner magnet, and surrounding the inner magnet;
a horizontally magnetized magnet disposed between the inner magnet and the outer magnet, and magnetized in a direction perpendicular to the magnetization directions of the inner magnet and the outer magnet, and in a direction from the inner magnet to the outer magnet, or from the outer magnet to the inner magnet; and
a yoke arranged to face toward the target across the magnets interposed therebetween so that a magnetic flux passes through the yoke between the inner magnet and the outer magnet,
wherein a value of magnetic coercive force of the horizontally magnetized magnet is greater in a region closer to the target side than in a center of an interior of the horizontally magnetized magnet.

2. The magnetic circuit according to claim 1, wherein
each of the magnets comprises a NdFeB rare-earth magnet, and
a concentration of Dy or Tb in the horizontally magnetized magnet is greater in a target side region than in a center of an interior of the horizontally magnetized magnet.

3. The magnetic circuit according to claim 1 or 2, wherein
a dimension of the horizontally magnetized magnet in a direction perpendicular to a target-facing surface of the horizontally magnetized magnet is from 5 to 30 mm.

4. A magnetron sputtering apparatus, comprising the magnetic circuit according to any one of claims 1 to 3.
